# EUROPEAN PATENT APPLICATION

(11) **EP 2 498 284 A2**
(43) Date of publication of application: **12.09.2012**
(21) Application number: 11172138.7
(22) Date of filing: 30.06.2011
(51) Int. Cl.: H01L 21/56

(54) **Method of fabricating a semiconductor package**

(30) Priority: 25.02.2011 TW 100106344
(71) Applicant: UTAC (Taiwan) Corporation, Hsinchu T'ai pei (TW)
(72) Inventor: Tsai, Shiann-Tsong, Hsinchu (TW)
(74) Representative: Epping - Hermann - Fischer

(57) **Abstract**

A method of fabricating a semiconductor package structure is provided that includes: providing a chip having an active surface and a plurality of conductive bumps formed on the active surface, and a base substrate having an underfill layer formed on a surface thereof; attaching the active surface of the chip to the underfill layer, such that the conductive bumps are embedded in the underfill layer; removing the base substrate to expose the underfill layer; and attaching the chip to a package substrate via the underfill layer, such that the chip is electrically connected to the package substrate by the conductive bumps. Since the underfill layer is attached to the active surface of the chip first, and the underfill layer is provided on the package substrate, performing a soldering process is not needed, material cost is decreased, and the fabrication process is simplified.

## Description

### BACKGROUND OF THE INVENTION

### 1. Field of the Invention

The present invention relates to methods of fabricating a semiconductor device, and, more particularly, to a method of fabricating a semiconductor package structure having a chip attached to a package substrate.

### 2. Description of Related Art

Followed by the flourishing development of electronic industries, electronic products are designed to meet the low-profile, compact-size, high integration and multi-function requirements. In order to satisfy the packaging requirement of package structures, such as high integration and miniaturization, in addition to installing a ball grid array (BGA) onto a package substrate, the package form develops from wire-bonding package to flip-chip (FC) package, wherein such kind of package member may prevent the gold wires from occupying spaces and thus effectively decrease the size of a semiconductor device as a whole while enhancing the electrical function.

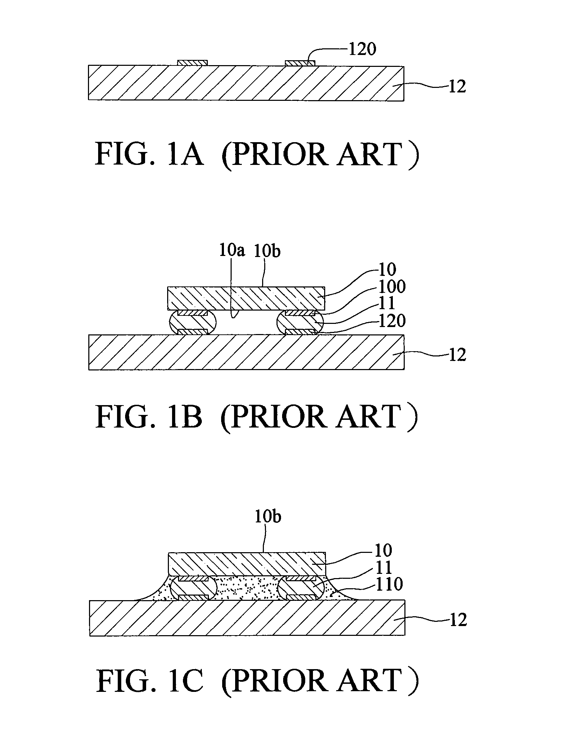

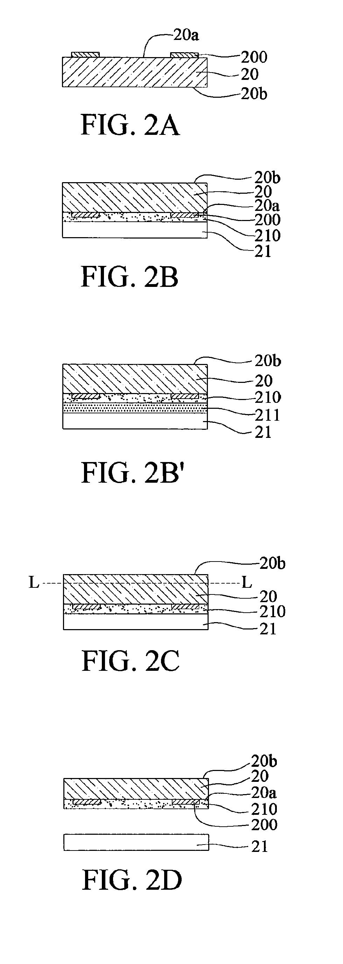

FIGs. 1A-1C are illustrative diagrams of a method of fabricating a flip-chip package structure according to the prior art. As illustrated in FIG. 1A, a package substrate 12 having pads 120 on a surface thereof is provided. As illustrated in FIG. 2B, a chip 10 having an active surface 10a and a non-active surface 10b opposing the active surface 10a is provided, and the active surface 10a has a plurality of conductive bumps 100 disposed thereon. A soldering process is performed, for the conductive bumps 100 to be electrically connected to the pads 120 by solder bumps 11, such that the chip 10 is disposed on the package substrate 12. As illustrated in FIG. 2C, an underfill layer 110 is formed between the active surface 10a of the chip 10 and the package substrate 12, such that the underfill layer 110 may encapsulates the solder bumps 11, thereby completing a flip-chip process.

However, in the method of fabricating the flip-chip package structure according to the prior art, the soldering process and the underfill filling process have to be performed sequentially. As a result, the material cost is increased due to the use of the solder material, and the process becomes more complicated.

Hence, it has substantially become an issue to be solved immediately at the present time that how to overcome the above-mentioned problem of the manufacturing method in the art.

### SUMMARY OF THE INVENTION

In view of the above-mentioned problems of the prior art, the present invention provides a method of fabricating a semiconductor package structure, comprising: providing a chip having an active surface and a plurality of conductive bumps formed on the active surface, and a base substrate having an underfill layer formed on a surface thereof; attaching the active surface of the chip to the underfill layer, such that the conductive bumps are embedded in the underfill layer; removing the base substrate to expose the underfill layer; and attaching the chip to a package substrate via the underfill layer, such that the chip is electrically connected to the package substrate by the conductive bumps.

In an embodiment of the present invention, the base substrate is removed by a peeling process. In order to readily peel the substrate, the binding force between the substrate material and the underfill layer is properly less than that between the active surface of the chip and the underfill layer.

In an embodiment of the present invention, a release layer is further formed between the base substrate and the underfill layer, such that the substrate is removed by peeling the release layer.

In the method according to the present invention, since the underfill layer protects the active surface of the chip, and the substrate can provide steady bearing and supporting performance, the non-active surface of the chip can be further polished prior to the removal of the base substrate.

In addition, the steps of attaching the chip to the package substrate via the underfill layer include heating and melting the underfill layer, for the conductive bumps to be electrically connected to the package substrate, and curing the underfill layer. Certainly, a packaging encapsulant may be further formed on the package substrate so as to encapsulate the chip.

Therefore, the method of fabricating the semiconductor package structure of the present invention attaches the underfill layer to the active surface of the chip first and then attaches the chip on the package substrate via the underfill layer. Compared to the prior art, the present invention not only has no need of performing a soldering process but also decreases material cost to thereby simplify the fabrication process.

### BRIEF DESCRIPTION OF DRAWINGS

FIGs. 1A-1C are schematically sectional diagrams of a method of fabricating a flip-chip substrate structure according to the prior art; and

FIGs. 2A-2E are schematically sectional diagrams of a method of fabricating a semiconductor package structure according to the present invention; FIGs. 2B' and 2D' are another embodiments of FIGs. 2B and 2D.

### DETAILED DESCRIPTION OF PREFERRED EMBODIMENTS

The following specific embodiments are provided to illustrate the implementation way of the present invention, other advantages and effects can be apparently understood by one skilled in the art by the disclosure of this specification.

It has to be illustrated that the structures, proportions, sizes depicted in the accompanying figures of the specification merely cooperate with the disclosure of the specification so as to provide for one skilled in the art to understand and read rather than restricting an implementable limitation of the present invention, and do not constitute any substantial technical meaning. Any variations or alterations to the structures, proportional relations or sizes should be encompassed within the scope of the disclosure without affecting the effect generated by and the purpose achieved by the present invention.

Please referring to FIGs. 2A-2E, a method of fabricating a semiconductor package structure according to the present invention is provided.

As illustrated in FIG. 2A, a chip 20 having an active surface 20a and a non-active surface 20b opposing the active surface 20a is provided, and the active surface 20a has a plurality of conductive bumps 200 thereon.

As illustrated in FIG. 2B, a base substrate 21 having an underfill layer 210 formed on a surface thereof is provided, and the active surface 20a of the chip 20 is attached onto the underfill layer 210 such that the conductive bumps 200 are embedded into the underfill layer 210. In an embodiment of the present invention, the underfill layer 210 may be a non-conductive film (NCF, NAMICS CORPORATION), and may protect the conductive bumps 200 from being polished during a polishing process. In an embodiment of the embodiment, the binding force between the base substrate 21 and the underfill layer 210 is less than that between the active surface 20a and the underfill layer 210.

In another embodiment of the present invention, a release layer 211 is further formed between the base substrate 21 and the underfill layer 210, as illustrated in FIG. 2B'.

As illustrated in FIG. 2C, the non-active surface 20b of the chip 20 may be further polished to a dashed line L-L to reduce the thickness of the chip 20.

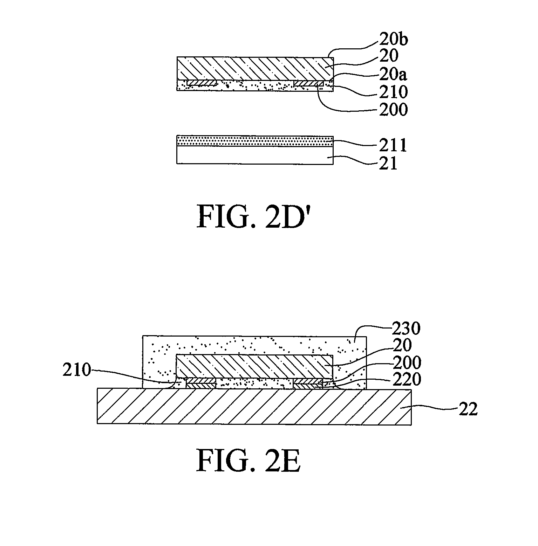

As illustrated in FIG. 2D, since the binding force between the base substrate 21 and the underfill layer 210 is less than that between the active surface 20a of the chip 20 and the underfill layer 210, the substrate 21 may be removed during a peeling process, such that the underfill layer 210 is attached on the active surface 20a.

As illustrated in FIG. 2D', if a removal process is performed with the structure shown in FIG, 2B', then the base substrate 21 is removed along with peeling off the release layer 211.

As illustrated in FIG. 2E, the chip 20 is mounted on a package substrate 22 via the underfill layer 210. After the underfill layer 210 is heated and melted, the conductive bumps 200 are in contact with the package substrate 22 and thus electrically connect pads 220 of the package substrate 22. Then, the underfill layer 210 is cured, such that the underfill layer 210 is adhered on the package substrate 22 and the chip 20 is thus fixed to the package substrate 22. In an embodiment of the present invention, a packaging encapsulant 230 is further formed on the package substrate 22 to encapsulate the chip 20.

The method of fabricating the semiconductor package structure according to the present invention combines the underfill layer 210 on the active surface 20a of the chip 20, and then provides the underfill layer 210 on the package substrate 22. Compared with the prior art, the present invention not only has no need of performing the soldering process and forming the underfill layer after soldering but also decreases material cost to simplify process steps.

The above-mentioned embodiments are used to exemplarily illustrate the principles of the present invention and the effects thereof rather than restricting the present invention. One skilled in the art could modify the above-mentioned embodiments without violating the spirit and scope of the present invention. Hence, the protection scope of the present invention should be listed as the latter-mentioned claims.

## Claims

1. A method of fabricating a semiconductor package structure, comprising:
providing a chip having an active surface and a plurality of conductive bumps formed on the active surface, and a base substrate having an underfill layer formed thereon;
attaching the active surface of the chip to the underfill layer, such that the conductive bumps are embedded in the underfill layer;
removing the base substrate to expose the underfill layer; and
attaching the chip to a package substrate via the underfill layer, such that the chip is electrically connected to the package substrate by the conductive bumps.

2. The method of claim 1, wherein the base substrate is removed by a peeling process.

3. The method of claim 2, wherein a binding force between the substrate and the underfill layer is less than that between the active surface of the chip and the underfill layer.

4. The method of claim 1, further comprising forming a release layer between the base substrate and the underfill layer, so as to remove the base substrate by peeling off the release layer from the underfill layer.

5. The method of claim 1, further comprising polishing a non-active surface of the chip that opposes the active surface, prior to removing the base substrate.

6. The method of claim 1, wherein attaching the chip to the package substrate via the underfill layer comprises the steps of heating and melting the underfill layer for the conductive bumps to be electrically connected to the package substrate, and curing the underfill layer.

7. The method of claim 1, further comprising forming a packaging encapsulant on the package substrate to encapsulate the chip.
